# EUROPEAN PATENT APPLICATION

(11) **EP 4 676 185 A1**
(43) Date of publication of application: **07.01.2026**
(21) Application number: 25171435.8
(22) Date of filing: 17.04.2025
(51) Int. Cl.: H10D 30/01, H10D 30/66, H10D 64/00, H10D 64/27, H10D 64/23, H10D 64/62

(54) **METHOD FOR MANUFACTURING SPLIT-GATE POWER DEVICE DEFINING TRENCHES IN ACTIVE REGION**

(30) Priority: 01.07.2024 CN 202410873557
(71) Applicant: Chongqing Alpha and Omega Semiconductor Limited, Chongqing 400700 (CN)
(72) Inventor: YANG, LI, Chongqing, 400700 (CN)
(74) Representative: Metida

(57) **Abstract**

A method for manufacturing a split-gate power device includes preparing at least one epitaxial layer (101) and a silicon oxide film (102) on a silicon substrate (100), etching upper portions of trenches on the at least one epitaxial layer (101); depositing silicon nitride protective films (112) on the trenches (110), and etching lower portions of the trenches (110) downward to form source trenches; forming voltage-resistant oxide layers (115) on the source trenches, and preparing shield gate polysilicon (116) in the source trenches; removing the silicon nitride protective films (112) to form gate trenches (118), forming gate oxide layers respectively on the gate trenches (118), simultaneously forming polysilicon interlayer oxide layers (117) on the shield gate polysilicon (116); forming gate polysilicon in the gate trenches (118); forming body regions (121) and source regions (122); preparing contact holes and tungsten plugs (136); and forming a circuit and a passivation layer (128).

## Description

### TECHNICAL FIELD

The present disclosure relates to a field of power device manufacturing, and in particular to a method for manufacturing a split-gate power device defining trenches in an active region.

### BACKGROUND

As all sectors of society pay more attention to environmental protection, power devices are essential in electronic power applications due to their energy-saving and power-saving characteristics. In particular, split-gate power devices are favored by market applications because of their characteristics such as low on-resistance, fast turn-on speed, and low switching loss.

A conventional manufacturing method for a split-gate power device with self-defined trenches in an active region comprises growing an epitaxial layer on a silicon substrate; forming trenches in the epitaxial layer; performing an oxidation process on a voltage-resistant dielectric layer at bottom portions of the trenches; forming source polysilicon in a middle lower portion of each of the trenches; performing high-density plasma deposition of silicon oxide to form polysilicon interlayer silicon oxide; forming the tranches in the active region by dry or wet etching; forming gate polysilicon in the trenches of the active region; manufacturing body regions and source regions; forming a dielectric layer and manufacturing contact holes and tungsten plugs; forming a circuit connection; and forming a passivation layer. When etching the trenches in the active region, a gate-source capacitance may increase due to different etching rates of a silicon dioxide film that forms the voltage-resistant dielectric layer. Therefore, it is necessary to improve the conventional manufacturing method to solve a problem of increased gate-source capacitance.

### SUMMARY

In view of the defects in the prior art, the present disclosure provides a method for manufacturing a split-gate power device defining action region trenches.

The method for manufacturing the split-gate power device defining trenches in an active region comprises:
step S1: sequentially preparing at least one epitaxial layer and a silicon oxide film on a silicon substrate, and etching upper portions of trenches on the at least one epitaxial layer by a photolithography process according to a gate trench pattern and a source trench pattern;
step S2: depositing silicon nitride protective films on sidewalls, corresponding to the gate trench pattern, of the upper portions of the trenches, and etching lower portions of the trenches downward in regions thereof not covered by the silicon nitride protective films to form source trenches;
step S3: forming voltage-resistant oxide layers on side walls and bottom portions of lower portions of the source trenches by an oxidation process, and preparing shield gate polysilicon in the source trenches;
step S4: removing the silicon nitride protective films to form gate trenches, forming gate oxide layers respectively on the gate trenches by the oxidation process, and simultaneously forming polysilicon interlayer oxide layers on exposed regions of the shield gate polysilicon;
step S5: forming gate polysilicon in the gate trenches;
step S6: forming body regions and source regions through ion implantation;
step S7: preparing contact holes and tungsten plugs; and
step S8: forming a circuit by etching, and forming a passivation layer.

In the present disclosure, platform regions are protected by the silicon nitride protective films to avoid horizontal and vertical oxidation of the silicon around the platform regions during a manufacturing process of the voltage-resistant oxide layer. Therefore, the platform regions do not increase in width and depth, so gate trenches formed are not too wide nor too deep. The method of the present disclosure makes a width of the gate trenches narrower, thereby improving a distribution dispersion of a turn-on voltage of the power device. Further, the gate trenches are made shallower, thereby reducing a gate-source capacitance. In addition, by defining the gate trenches through the silicon nitride protective films, an active region mask and a polysilicon layer mask are omitted, which reduce process steps.

### BRIEF DESCRIPTION OF DRAWINGS

FIG. 1 is a flow chart of a method for manufacturing a split-gate power device defining trenches in an active region according to one embodiment of the present disclosure.
FIG. 2 is a schematic diagram of a structure of the split-gate power device after forming an epitaxial layer on a silicon substrate.
FIG. 3 is a schematic diagram of a structure of the split-gate power device after forming a silicon oxide film and a photoresist mask.
FIG. 4 is a schematic diagram of a structure of the split-gate power device after defining a gate trench pattern and a source trench pattern and etching the silicon oxide film.
FIG. 5 is a schematic diagram of a structure of the split-gate power device after forming upper portions of the trenches in a circuit pattern by etching.
FIG. 6 is a schematic diagram of a structure of the split-gate power device after deposition of silicon nitride.
FIG. 7 is a schematic diagram of a structure of the split-gate power device after forming silicon nitride protective films by etching the silicon nitride.
FIG. 8 is a schematic diagram of a structure of the split-gate power device after forming the source trenches by etching lower portions of the trenches.
FIG. 9 is a schematic diagram of a structure of the split-gate power device after forming voltage-resistant oxide layers.
FIG. 10 is a schematic diagram of a structure of the split-gate power device after depositing first polysilicon.
FIG. 11 is a schematic diagram of a structure of the split-gate power device after forming shield gate polysilicon.
FIG. 12 is a schematic diagram of a structure of the split-gate power device after forming gate trenches by removing the silicon nitride protective films.
FIG. 13 is a schematic diagram of a structure of the split-gate power device after forming polysilicon interlayer oxide layers and gate oxide layers.
FIG. 14 is a schematic diagram of a structure of the split-gate power device after depositing second polysilicon.
FIG. 15 is a schematic diagram of a structure of the split-gate power device after forming gate polysilicon.
FIG. 16 is a schematic diagram of a structure of the split-gate power device after forming the body regions.
FIG. 17 is a schematic diagram of a structure of the split-gate power device after forming the source regions.
FIG. 18 is a schematic diagram of a structure of the split-gate power device after forming a silicon dioxide dielectric layer.
FIG. 19 is a schematic diagram of a structure of the split-gate power device after forming contact holes.
FIG. 20 is a schematic diagram of a structure of the split-gate power device after forming an ohmic contact structure at a bottom portion of each of the contact holes.
FIG. 21 is a schematic diagram of a structure of the split-gate power device after forming tungsten plugs in the contact holes.
FIG. 22 is a schematic diagram of a structure of the split-gate power device after depositing aluminum-copper compound.
FIG. 23 is a schematic diagram of a structure of the split-gate power device after forming gate metal pads and a source metal pad.
FIG. 24 is a schematic diagram of a structure of the split-gate power device after forming a passivation layer.
FIG. 25 is a schematic diagram of a structure of the split-gate power device after etching the passivation layer.

### DETAILED DESCRIPTION

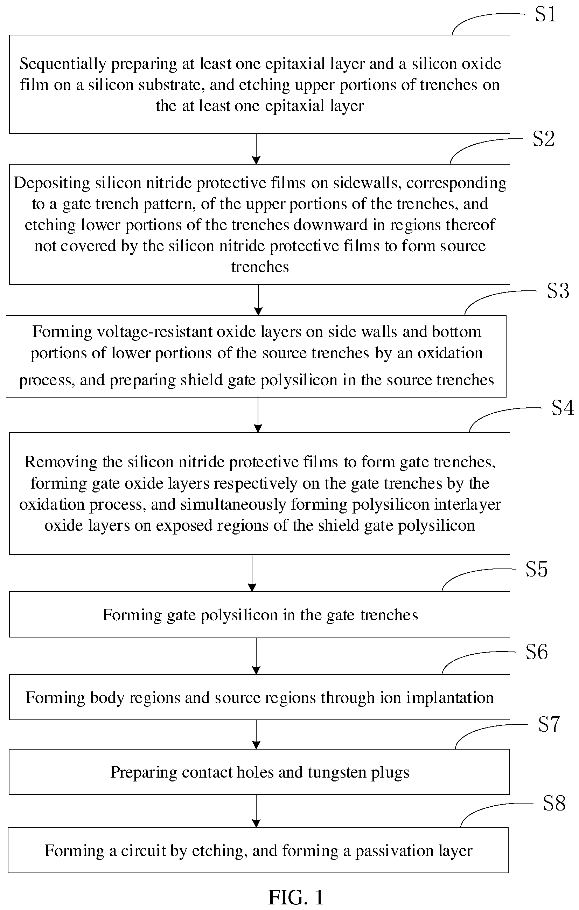

FIG. 1 is a flow chart of a method for manufacturing a split-gate power device defining trenches in an active region according to one embodiment of the present disclosure.

The method for manufacturing the split-gate power device defining the trenches in the active region comprises steps S1-S8.

The step S1 comprises sequentially preparing at least one epitaxial layer 101 and a silicon oxide film 102 on a silicon substrate 100, and etching upper portions of trenches 110 on the at least one epitaxial layer 101 by a photolithography process according to a gate trench pattern 104 and a source trench pattern 105. Sidewalls of the upper portions of the trenches 110 are corresponding to the gate trench pattern 104, and middle regions of the upper portions of the trenches 110 are corresponding to the source trench pattern 105. The step S1 comprises S110-S160.

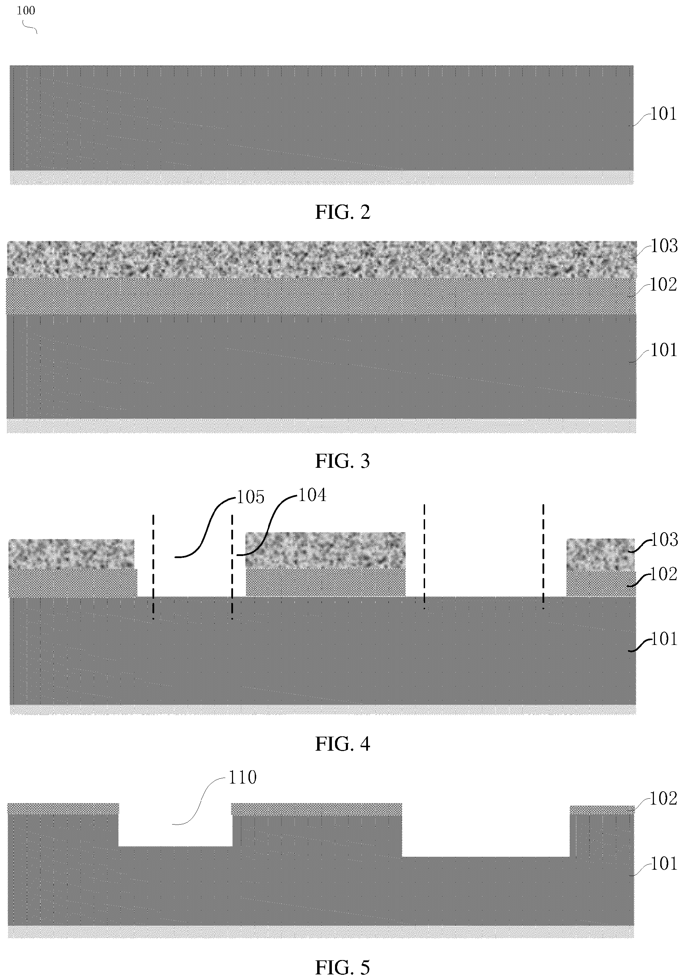

As shown in FIG. 2, the step S110 comprises forming the at least one epitaxial layer 101 on the silicon substrate 100. The at least one epitaxial layer 101 may be one or more epitaxial layers 101. At this time, trivalent elements or pentavalent elements are generally doped into the at least one epitaxial layer 101.

As shown in FIG. 3, the step S120 comprises depositing the silicon oxide film 102 on an upper surface of the least one epitaxial layer 101.

As shown in FIG. 3, the step S130 comprises depositing a photoresist mask 103 on the silicon oxide film 102. The photoresist mask 103 is composed of photoresist or a multi-layer structure composed of photoresist and other insulator masks, and the photoresist is spin-coated by the photolithography process.

As shown in FIG. 4, the step S140 comprises defining the gate trench pattern 104 configured to form the gate trenches 118 and the source trench pattern 105 configured to form the source trenches on the photoresist mask 103. The source trenches comprise a shield gate trench 113 and a shield gate interconnection trench 114.

As shown in FIG. 4, the step S150 comprises etching the silicon oxide film 102 in regions respectively corresponding to the gate trench pattern 104 and the source trench pattern 105 by a dry etching process to expose first exposed regions of the at least one epitaxial layer 101.

As shown in FIG. 5, the step S160 comprises removing the photoresist mask 103 by a wet etching process after forming a circuit pattern on the silicon oxide film 102, dry etching the first exposed regions of the at least one epitaxial layer 101, and forming the upper portions of the trenches 110 of a circuit pattern on the first exposed regions of the at least one epitaxial layer 101.

The step S2 comprises depositing silicon nitride protective films 112 on sidewalls, corresponding to the gate trench pattern 104, of the upper portions of the trenches 110, and etching lower portions of the trenches 110 downward in regions thereof not covered by the silicon nitride protective films 112 to form source trenches. The source trenches are the shield gate trench 113 and the shield gate interconnection trench 114.

The step S2 comprises steps S210-S230.

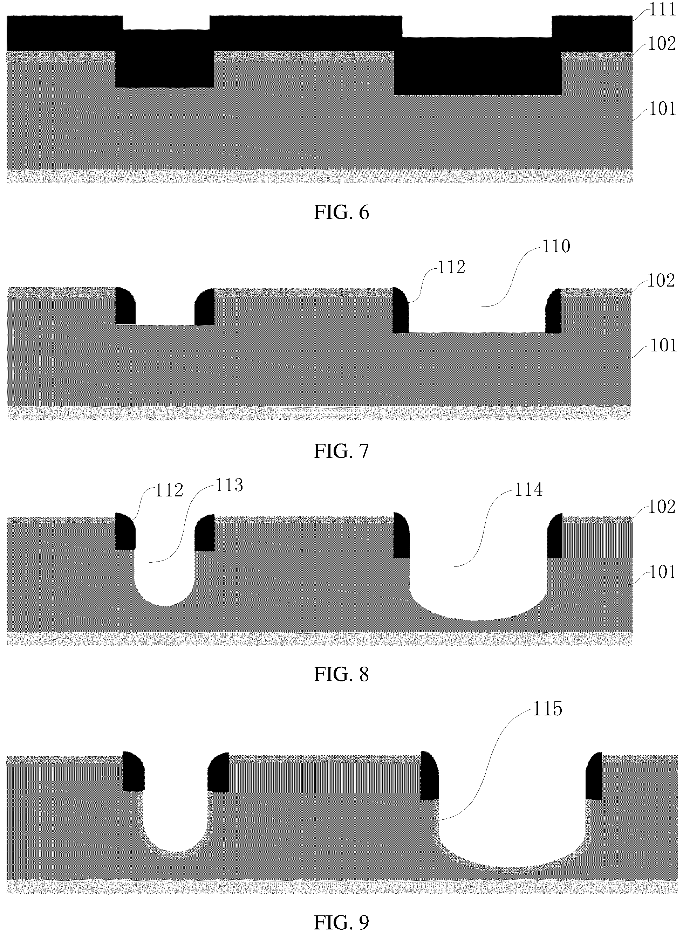

As shown in FIG. 6, the step S210 comprises depositing silicon nitride 111 on the silicon oxide film 102 and an interior of each of the trenches 110 by a silicon nitride deposition process. At this time, a thickness of the silicon nitride 111 deposited above the gate trench pattern 104 is greater than a thickness of the silicon nitride 111 in other regions.

As shown in FIG. 7, the step S220 comprises removing a first part of the silicon nitride 111 on the silicon oxide film 102 and a second part of the silicon nitride 111 in a region corresponding to the source trench pattern 105 in a middle portion of each of the trenches 110. Since an etching speed in a horizontal direction is much less than an etching speed in a vertical direction, and a thickness of the silicon nitride 111 deposited above the gate trench pattern 104 is relatively thick, a third part of the silicon nitride 111 in regions corresponding to the sidewalls and the gate trench pattern 104 is kept as the silicon nitride protective films 112. In the step, the silicon oxide film 102 above the surface of the silicon substrate 100 is retained.

As shown in FIG. 8, the step S230 comprises etching the lower portions of the trenches 110 in the regions not covered by the silicon nitride protective films 112 to form the source trenches, so that the lower portions of the trenches 110 and the upper portions of the trenches 110 that are not covered by the silicon nitride protective films 112 form the shield gate trench 113 and the shield gate interconnection trench 114. The regions covered by the silicon nitride protective film 112 are not etched downward, so platform regions are formed.

The step S3 comprises forming voltage-resistant oxide layers 115 on side walls and bottom portions of lower portions of the source trenches by an oxidation process, and preparing shield gate polysilicon 116 in the source trenches.

The step S3 comprises steps S310-S330.

As shown in FIG. 9, the step S310 comprises growing oxide layers respectively on the sidewalls and the bottom portions of the lower portions of the trenches 110 by a high-temperature oxidation process to form the voltage-resistant oxide layers 115. At this time, the platform regions (i.e., the regions corresponding to the gate trench pattern 104) are covered by the silicon nitride protective film 112, and no oxide layer will grow. Since the sidewalls of the upper portions of the trenches 110 are covered by the silicon nitride protective film 112, the lower portions of the trenches 110 are wider than the upper portions after oxidation. Of course, at this time, the uppermost surface of the structure is covered by the silicon oxide film 102, and no oxide layer will grow.

In the prior art, the platform regions are oxidized during a process of manufacturing the voltage-resistant oxide layers 115, so that the silicon around the platform regions is oxidized horizontally and vertically, causing the platform regions being wider and deeper than that of the present disclosure, and making the gate trenches formed eventually too wide and too deep. In the embodiment, the platform regions are protected by the silicon nitride protective films 112, so the silicon around the platform regions are not oxidized horizontally and vertically in the step.

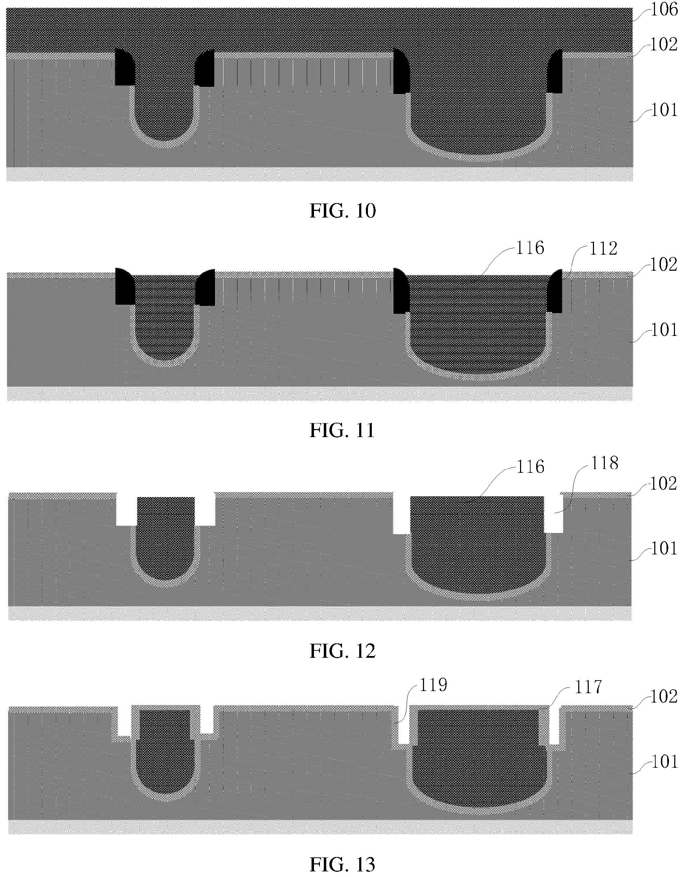

As shown in FIG. 10, the step S320 comprises integrally depositing first polysilicon 106 on the silicon oxide film 102 and the source trenches by chemical vapor deposition, so that the shield gate trench 113 and the shield gate interconnection trench 114 are filled with the first polysilicon. At this time, a layer of the first polysilicon 106 is formed on the silicon oxide film 102.

As shown in FIG. 11, the step S330 comprises removing a first part of the first polysilicon 106 outside the shield gate trench 113 and the shield gate interconnection trench 114 (that is, the first polysilicon 106 formed on the silicon oxide film 102) and a second part of the first polysilicon 106 exceeding a height of the shield gate trench 113 and the shield gate interconnection trench 114, and reserving a third part of the first polysilicon 106 filled in the shield gate trench 113 and the shield gate interconnection trench 114 as the shield gate polysilicon 116. At this time, it is also possible to choose whether to perform ion implantation on the shield gate polysilicon 116 according to requirements.

The step S4 comprises removing the silicon nitride protective films 112 to form gate trenches 118, forming gate oxide layers 119 respectively on the gate trenches 118 by the oxidation process, and simultaneously forming polysilicon interlayer oxide layers 117 on exposed regions of the shield gate polysilicon 116.

The step S4 comprises steps S410-S420.

As shown in FIG. 12, the step S410 comprises removing, by hot phosphoric acid, the silicon nitride protective films 112 in the source trenches (i.e., the platform regions) to form gate trenches 118, and exposing upper portions of the shield gate polysilicon 116 and second exposed regions of the at least one epitaxial layer 101 through the gate trenches 118, Since the platform regions are protected by the silicon nitride protective films 112, in the embodiment, the gate trenches 118 are prevented from being too wide due to the consumption of silicon in a horizontal oxidation reaction, thereby improving a distribution dispersion of a turn-on voltage of the split-gate power device. At the same time, the gate trenches 118 are prevented from additionally consuming of silicon dioxide in the vertical direction due to wet etching after the oxidation reaction in the conventional process in the prior art, thereby reducing the gate-source capacitance.

As shown in FIG. 13, the step S420 comprises forming the polysilicon interlayer oxide layers 117 on the exposed regions of the shield gate polysilicon 116 by the high-temperature oxidation process, and forming the gate oxide layers 119 on second exposed regions of the at least one epitaxial layer 101.

It should be noted that a thickness of the gate oxide layers 119 formed in the step S420 is much less than a thickness of the voltage-resistant oxide layers 115 formed in the step S310. The thickness of the gate oxide layers 119 is generally only about one tenth of the thickness of the voltage-resistant oxide layers 115. FIG. 13 is only a schematic diagram and does not represent an actual thickness ratio of the gate oxide layers 119 formed in the step S420 to the voltage-resistant oxide layers 115. In addition, due to applications of the wet oxygen oxidation process and the relationship between the number of polysilicon lattices, the polysilicon interlayer oxide layers 117 grown on the shield gate polysilicon 116 is thicker than the gate oxide layers 119, thereby reducing the gate-source capacitance.

The step S5 comprises forming gate polysilicon 120 in the gate trenches 118.

The step S5 comprises steps S510-S520.

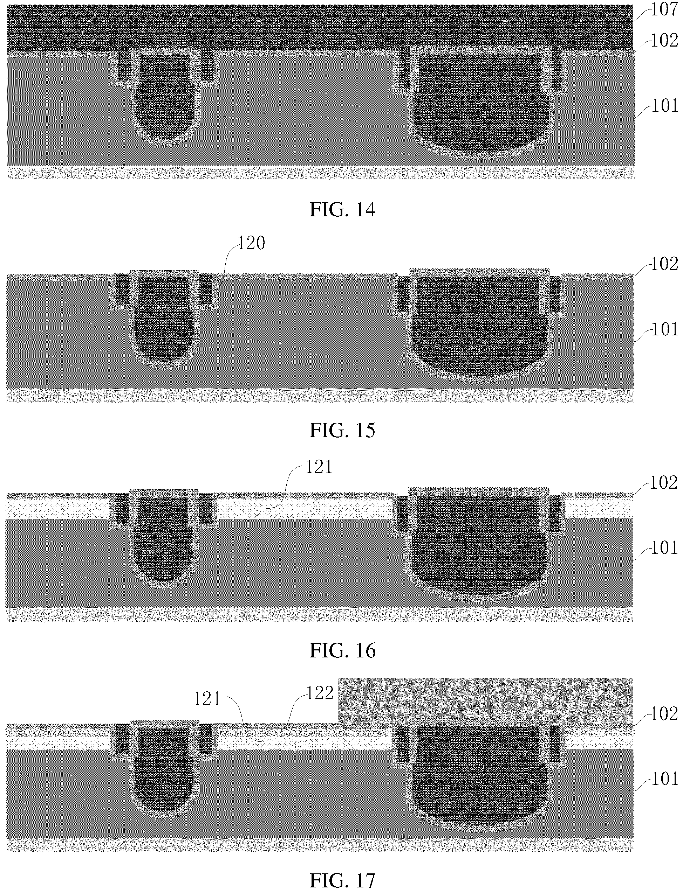

As shown in FIG. 14m the step S510 comprises integrally depositing second polysilicon 107 on a structure obtained after the step S420 by chemical vapor deposition, so that the gate trenches 118 are filled with the second polysilicon 107. At this time, the second polysilicon 107 is formed on the silicon oxide film 102 of the silicon substrate 100 and on the polysilicon interlayer oxide layers 117 above the shield gate polysilicon 116 .

As shown in FIG. 15, the step S520 comprises removing a first part of the second polysilicon 107 outside the gate trenches 118 and a second part of the second polysilicon 107 exceeding a height of the gate trenches 118 by chemical mechanical polishing and plasma etching, and retaining a third part of the polysilicon filled in the gate trenches 118 as the gate polysilicon 120.

The step S6 comprises forming body regions 121 and source regions 122 through ion implantation. The step S6 comprises steps S610-S620.

As shown in FIG. 16, step S610 comprises implanting first impurities on an upper surface of the at least one epitaxial layer 101 through the ion implantation to form the body regions 121, and activating the first impurities in the body regions 121 through a thermal process. The first impurities may be the trivalent element or the pentavalent element.

As shown in FIG. 17, the step S620 comprises defining the source regions 122 by the photolithography process, and implanting second impurities on upper surfaces of the body regions 121 to form the source regions 122 and obtain cell structures. The second impurities may be the pentavalent element or the trivalent element, and a polarity of the second impurities is opposite to a polarity of the first impurities implanted when forming the body regions 121 in the step S610. That is, when the first impurities implanted in the step S610 are the trivalent element, the second impurities implanted in the step S620 is the pentavalent element, or when the first impurities implanted in the step S610 are the pentavalent element, the second impurities implanted in the step S620 are the trivalent element.

The step S7 comprises preparing contact holes and tungsten plugs 136. The step S7 comprises steps S710-S760.

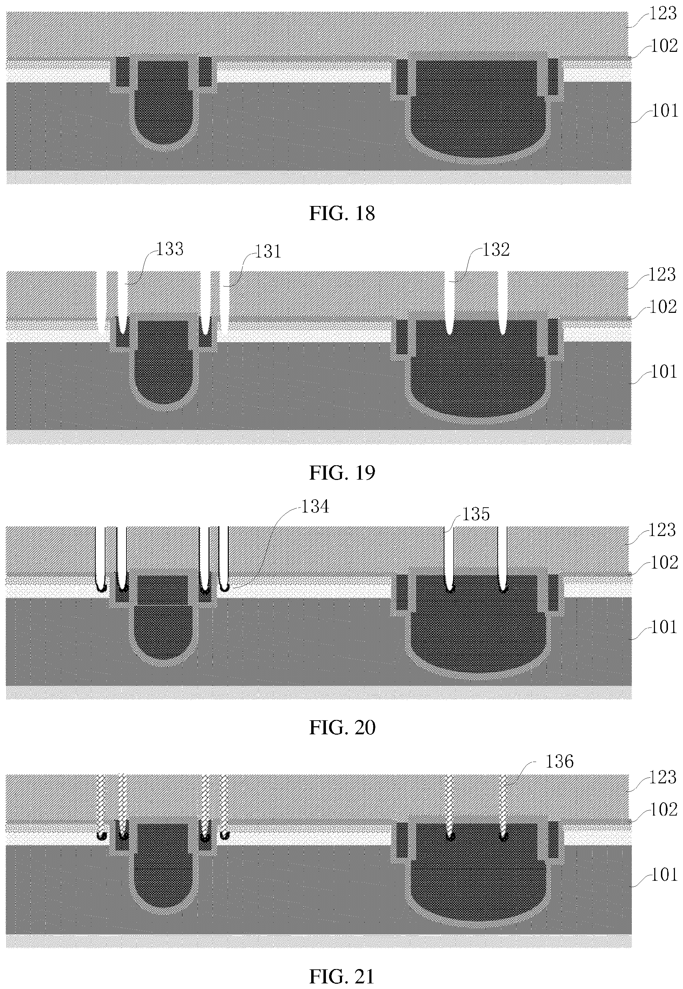

As shown in FIG. 18, the step S710 comprises forming a silicon dioxide dielectric layer 123 on an upper surface of a structure obtained after the step S620 by the chemical vapor deposition.

The step S720 comprises defining patterns of the contact holes by using photoresist through the photolithography process. The contact holes comprise source region contact holes 125, source region polysilicon interconnection contact holes 132, and gate polysilicon contact holes 133. That is, the patterns of the contact holes comprises source region contact hole patterns, source region polysilicon interconnection contact hole patterns, and gate polysilicon contact hole patterns. The source region contact hole patterns are respectively located directly above the source regions 122, the source region polysilicon interconnection contact hole patterns are located directly above the shield gate interconnection trenches 114, and the gate polysilicon contact hole patterns are located directly above the gate trenches 118.

As shown in FIG. 19, the step S730 comprises forming the contact holes by dry etching silicon dioxide dielectric layer 123 the silicon layer on corresponding regions of the patterns of the contact holes. That is, the source contact holes 131 respectively extending into the source regions 122, the source polysilicon interconnection contact holes 132 extending into the shield gate polysilicon 116, and the gate polysilicon contact holes 133 extending into the gate polysilicon 120 are formed.

As shown in FIG. 20, the step S740 comprises doping third impurities of a high concentration into a bottom portion of each of the contact holes by the ion implantation, forming an ohmic contact structure 134 at the bottom portion of each of the contact holes, and activating the third impurities through rapid thermal annealing. A polarity of the third impurities implanted in the step S740 is opposite to the polarity of the second impurities implanted when the source regions 122 are formed in the step S620, that is, the polarity of the third impurities is the same as the polarity of the first impurities implanted when the body regions 121 are formed in the step S610.

As shown in FIG. 20, the step S750 comprises depositing metal and nitride on a hole wall of each of the contact holes through a physical vapor deposition process, and forming a silicide protective layer 135 on the hole wall of each of the contact holes by the thermal annealing. The metal deposited in the step S750 is selected from one or more of titanium, cobalt, and tantalum.

As shown in FIG. 21, the step S760 comprises depositing metal tungsten in each of the contact holes by a tungsten plug process, removing the metal tungsten outside the contact holes by the dry etching process, and forming the tungsten plugs 136 respectively in the contact holes. Since each silicide protective layer 135 is formed on the hole wall of each of the contact holes to isolate the metal tungsten, diffusion between the metal tungsten and silicon is avoided.

The step S8 comprises forming a circuit by etching, and forming a passivation layer 128. The step S8 comprises steps S810-S840.

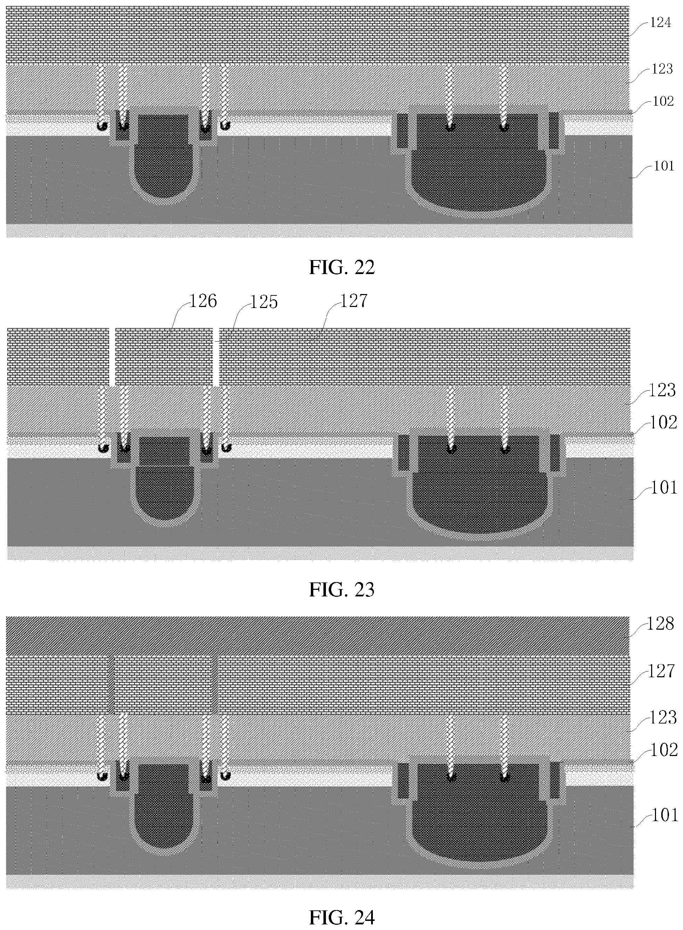

As shown in FIG. 22, the step S810 comprises depositing an aluminum-copper compound 124 on the tungsten plugs 136 through the physical vapor deposition process.

As shown in FIG. 23, the step S820 comprises dry etching on the aluminum-copper compound 124 to form isolation regions 125 by the photolithography process, and dividing the aluminum-copper compound 124 into forming gate metal pads 126 and a source metal pad 127 by the isolation regions 125.

As shown in FIG. 24, the step S830 comprises forming the passivation layer 128 on the aluminum-copper compound 124 by the chemical vapor deposition.

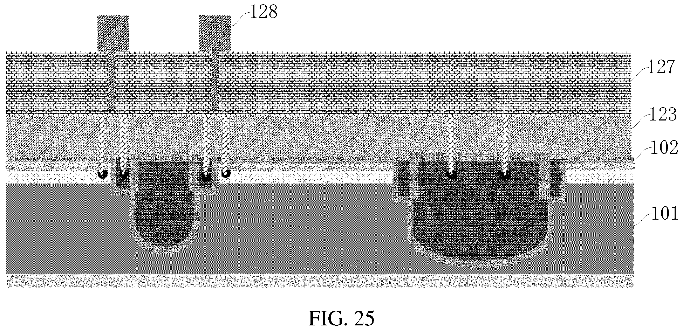

As shown in FIG. 25, the step S840 comprises dry etching the passivation layer 128 by the photolithography process to partially expose the gate metal pads 126 and the source metal pad 127, Subsequent packaging process is performed on exposed regions of the gate metal pads 126 and the source metal pad 127 to realize circuit connection.

In the present disclosure, platform regions are protected by the silicon nitride protective films 112 to avoid horizontal and vertical oxidation of the silicon around the platform regions during the manufacturing process of the voltage-resistant oxide layer 115. Therefore, the platform regions do not increase in width and depth, so gate trenches 118 formed are not too wide nor too deep. The method of the present disclosure makes a width of the gate trenches 118 narrower, thereby improving the distribution dispersion of the turn-on voltage of the split-gate power device. Further, the gate trenches 118 is made shallower, thereby reducing the gate-source capacitance. In addition, by defining the gate trenches 118 through the silicon nitride protective films 112, an active region mask and a polysilicon layer mask are omitted, which reduce process steps.

## Claims

1. A method for manufacturing a split-gate power device defining trenches in an active region, comprising:
step S1: sequentially preparing at least one epitaxial layer (101) and a silicon oxide film (102) on a silicon substrate (100), and etching upper portions of trenches (110) on the at least one epitaxial layer (101) by a photolithography process according to a gate trench pattern (104) and a source trench pattern (105);
step S2: depositing silicon nitride protective films (112) on sidewalls, corresponding to the gate trench pattern (104), of the upper portions of the trenches (110), and etching lower portions of the trenches (110) downward in regions thereof not covered by the silicon nitride protective films (112) to form source trenches;
step S3: forming voltage-resistant oxide layers (115) on side walls and bottom portions of lower portions of the source trenches by an oxidation process, and preparing shield gate polysilicon (116) in the source trenches;
step S4: removing the silicon nitride protective films (112) to form gate trenches (118), forming gate oxide layers respectively on the gate trenches (118) by the oxidation process, and simultaneously forming polysilicon interlayer oxide layers (117) on exposed regions of the shield gate polysilicon (116);
step S5: forming gate polysilicon (120) in the gate trenches (118);
step S6: forming body regions (121) and source regions (122) through ion implantation;
step S7: preparing contact holes and tungsten plugs (136); and
step S8: forming a circuit by etching, and forming a passivation layer (128).

2. The method according to claim 1, wherein the step S1 comprises:
step S110: forming the at least one epitaxial layer (101) on the silicon substrate (100);
step S 120: depositing the silicon oxide film (102) on an upper surface of the least one epitaxial layer (101);
step S130: depositing a photoresist mask (103) on the silicon oxide film (102);
step S140: defining the gate trench pattern (104) configured to form the gate trenches (118) and the source trench pattern (105) configured to form the source trenches on the photoresist mask (103);
step S150: etching the silicon oxide film (102) in regions respectively corresponding to the gate trench pattern (104) and the source trench pattern (105) by a dry etching process to expose first exposed regions of the at least one epitaxial layer (101); and
step S160: removing the photoresist mask (103), etching the first exposed regions of the at least one epitaxial layer (101), and forming the upper portions of the trenches (110) on the first exposed regions of the at least one epitaxial layer (101).

3. The method according to claim 2, wherein the step S2 comprises:
step S210: depositing silicon nitride (111) on the silicon oxide film (102) and an interior of each of the trenches (110);
step S220: removing a first part of the silicon nitride (111) on the silicon oxide film (102) and a second part of the silicon nitride (111) in a region corresponding to the source trench pattern (105) in a middle portion of each of the trenches (110), and defining a third part of the silicon nitride (111) in regions corresponding to the sidewalls and the gate trench pattern (104) as the silicon nitride protective films (112); and
step S230: etching the lower portions of the trenches (110) in the regions not covered by the silicon nitride protective films (112) to form the source trenches.

4. The method according to claim 3, wherein the step S3 comprises:
step S310: growing oxide layers respectively on the sidewalls and the bottom portions of the lower portions of the trenches (110) by a high-temperature oxidation process to form the voltage-resistant oxide layers (115);
step S320: integrally depositing first polysilicon (106) on the silicon oxide film (102) and the source trenches by chemical vapor deposition, so that the source trenches are filled with the first polysilicon (106); and
step S330: removing a first part of the first polysilicon (106) outside the source trenches and a second part of the first polysilicon (106) exceeding a height of the source trenches, and reserving a third part of the first polysilicon (106) filled in the source trenches as the shield gate polysilicon (116).

5. The method according to claim 4, wherein the step S4 comprises:
step S410: removing the silicon nitride protective films (112) in the source trenches to form gate trenches (118), and exposing upper portions of the shield gate polysilicon (116) and second exposed regions of the at least one epitaxial layer (101) through the gate trenches (118); and
step S420: forming the polysilicon interlayer oxide layers (117) on the exposed regions of the shield gate polysilicon (116) by the high-temperature oxidation process, and forming the gate oxide layers on second exposed regions of the at least one epitaxial layer (101).

6. The method according to claim 5, wherein the step S5 comprises:
step S510: integrally depositing second polysilicon (107) on a structure obtained after the step S420 by chemical vapor deposition, so that the gate trenches (118) are filled with the second polysilicon (107); and
step S520: removing a first part of the second polysilicon (107) outside the gate trenches (118) and a second part of the second polysilicon (107) exceeding a height of the gate trenches (118), and retaining a third part of the polysilicon filled in the gate trenches (118) as the gate polysilicon (120).

7. The method according to claim 6, wherein the step S6 comprises:
step S610: implanting first impurities on an upper surface of the at least one epitaxial layer (101) through the ion implantation to form the body regions (121), and activating the first impurities in the body regions (121) through a thermal process; and
step S620: defining the source regions (122) by the photolithography process, and implanting second impurities on upper surfaces of the body regions (121) to form the source regions (122).

8. The method according to claim 7, wherein the step S7 comprises:
step S710: forming a silicon dioxide dielectric layer (123) on an upper surface of a structure obtained after the step S620 by the chemical vapor deposition;
step S720: defining patterns of the contact holes by using photoresist through the photolithography process, wherein the contact holes comprise source region contact holes (131), source region polysilicon interconnection contact holes (132), and gate polysilicon contact holes (133);
step S730: forming the contact holes by dry etching corresponding regions of the patterns of the contact holes;
step S740: doping third impurities of a high concentration into a bottom portion of each of the contact holes by the ion implantation, forming an ohmic contact structure (134) at the bottom portion of each of the contact holes, and activating the third impurities through rapid thermal annealing;
step S750: depositing metal and nitride on a hole wall of each of the contact holes through a physical vapor deposition process, and forming a silicide protective layer on the hole wall of each of the contact holes by the rapid thermal annealing; and
step S760: depositing metal tungsten in each of the contact holes, removing the metal tungsten outside the contact holes by dry etching, and forming the tungsten plugs (136) respectively in the contact holes.

9. The method according to claim 8, wherein a polarity of the third impurities in the step S740 is the same as a polarity of the first impurities in the step S610, and a polarity of the second impurities in the step S620 is opposite to the polarity of the third impurities in the step S620; and/or
the metal deposited in the step S750 is selected from one or more of titanium, cobalt, and tantalum.

10. The method according to claim 8 or claim 9, wherein the step S8 comprises:
step S810: depositing an aluminum-copper compound (124) on the tungsten plugs (136) through the physical vapor deposition process;
step S820: dry etching on the aluminum-copper compound (124) to form isolation regions (125) by the photolithography process, and dividing the aluminum-copper compound (124) into gate metal pads (126) and a source metal pad (127) by the isolation regions (125); and
step S830: forming the passivation layer (128) on the aluminum-copper compound (124) by the chemical vapor deposition; and
step S840: dry etching the passivation layer (128) by the photolithography process to partially expose the gate metal pads (126) and the source metal pad (127).
